# EUROPEAN PATENT APPLICATION

(11) **EP 4 585 881 A2**
(43) Date of publication of application: **16.07.2025**
(21) Application number: 25176808.1
(22) Date of filing: 15.05.2025
(51) Int. Cl.: G01B 9/02018

(54) **POSITION MEASUREMENT SYSTEM, PROJECTION SYSTEM, EXPOSURE APPARATUS AND A METHOD TO MEASURE A POSITION OF AN OBJECT**

(71) Applicant: ASML Netherlands B.V., 5500 AH Veldhoven (NL)
(72) Inventor: DUYS, Anton, Wilhelmus, 5500 AH Veldhoven (NL); WIDDERSHOVEN, Ivo, 5500 AH Veldhoven (NL); KWEE, Patrick, 5500 AH Veldhoven (NL)
(74) Representative: ASML Netherlands B.V.

(57) **Abstract**

The invention provides a position measurement system, comprising:
a light source to provide a measurement beam and a reference beam propagating along a common light beam path,
an optical device located in the common light beam path and downbeam of the light source, wherein the optical device is configured to induce or adjust an offset between the measurement beam and the reference beam,
interferometer optics downbeam of the optical device, the interferometer optics configured to propagate the measurement beam in multiple passes along measurement paths to a measurement surface and the reference beam in multiple passes along reference paths to a reference surface,
a detector to receive a reflected measurement beam and a reflected reference beam after a final pass of the multiple passes,
wherein a reflective surface in the measurement paths or the reference paths is tilted, such that an incident angle of the measurement beam or reference beam incident on the respective reflective surface is at a non-90 degrees angle and at a non-45 degrees angle with respect to the reflective surface.

## Description

### FIELD OF THE INVENTION

The present invention relates to a position measurement system. The invention also relates to a projection system for an optical lithography system, an exposure apparatus and a method to measure a position of an object.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning" -direction) while synchronously scanning the substrate parallel or anti-parallel to this direction. It is also possible to transfer the pattern from the patterning device to the substrate by imprinting the pattern onto the substrate.

In embodiments of a lithographic apparatus, position measurement systems, for example interferometer systems, are used to determine a change in the position of movable objects with high accuracy. Examples of these movable objects are a substrate support, a patterning device support and movable optical elements, for example mirrors of the projection optics box.

In some types of interferometer systems a light beam originating from a light source is used to provide a measurement beam and a reference beam, wherein a polarization difference is used to distinguish the measurement and the reference beam. A polarizing beam splitter may be used to propagate the measurement beam and the reference beam in the desired directions.

In such interferometer systems, measurement errors may occur due to ghost reflections and/or polarization leakages at the interferometer polarizing beam splitter, which in turn are reflected off the measurement and/or reference surfaces and detected alongside the interfering measurement beam and reference beam. Other optical elements may also cause ghost reflections and/or polarization leakages. To reduce the effects of ghost reflections and/or polarization leakages, optical elements, in particular beam splitters, of extremely high quality may be provided. These optical elements are difficult to produce and very costly. Moreover, in practice the effects of ghost reflections and/or polarization leakages cannot be completely removed by these high quality optical elements due to physical limitations or outside influences.

US2005110971, the contents of which are herein incorporated by reference, discloses an interferometer system in which a reflective surface of the interferometer measurement system is arranged such that a beam path of interferometer radiation of the interferometer measurement system incident on the reflective surface has an offset angle in the range of from about 0.1 to 10 milliradians with respect to the normal to said reflective surface. This tilted reflective surface is used to suppress the effect of additional beam paths in the interferometer system resulting from leakages, in particular additional beam paths in which a beam is reflected both on the measurement surface and the reference surface of the interferometer system.

However, due to the tilted surface the reflected measurement beam and the reflected reference beam received by the detector of the interferometer system may be shifted with respect to each other. This may have a negative effect on the quality of the measurement signal as received by the detector.

### SUMMARY OF THE INVENTION

It is an object of the invention to provide an improved position measurement system and/or method that can be used to improve measurement in a position measurement system with a tilted reflective surface to suppress the effect of additional beam paths in the position measurement system resulting from leakages, for example additional beam paths in which a beam is reflected both on the measurement surface and the reference surface of the interferometer system.

According to an aspect of the invention, there is provided a position measurement system, comprising:
a light source to provide a measurement beam and a reference beam propagating along a common light beam path,
an optical device located in the common light beam path and downbeam of the light source, wherein the optical device is configured to induce or adjust an offset between the measurement beam and the reference beam,
interferometer optics downbeam of the optical device, the interferometer optics configured to propagate the measurement beam in multiple passes to a measurement surface and the reference beam in multiple passes to a reference surface, and
a detector to receive a reflected measurement beam and a reflected reference beam after a final pass of the multiple passes,
wherein at least one of a surface of the interferometer optics, the measurement surface or the reference surface is tilted, such that an incident angle of the measurement beam and/or reference beam incident on the respective at least one surface of the interferometer optics, the measurement surface or the reference surface is non-perpendicular with respect to the at least one surface of the interferometer optics, the measurement surface or the reference surface.

According to an aspect of the invention, there is provided a projection system for an optical lithography system comprising the position measurement system of any of the claims 1-12.

According to an aspect of the invention, there is provided a lithographic apparatus comprising the interferometer system of any of the claims 1-12.

According to an aspect of the invention, there is provided a method to measure a position of an object using the position measurement system of any of the claims 1-12.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts schematically a lithographic apparatus;
- Figure 2 shows a known embodiment of a position measurement system
- Figure 3 shows a first embodiment of a position measurement system according to an aspect of the invention;
- Figure 4 shows a second embodiment of a position measurement system according to an aspect of the invention;
- Figure 5 shows a third embodiment of a position measurement system according to an aspect of the invention; and
- Figure 6 shows an alternative embodiment of an optical device of the position measurement system of Figure 5.

### DETAILED DESCRIPTION

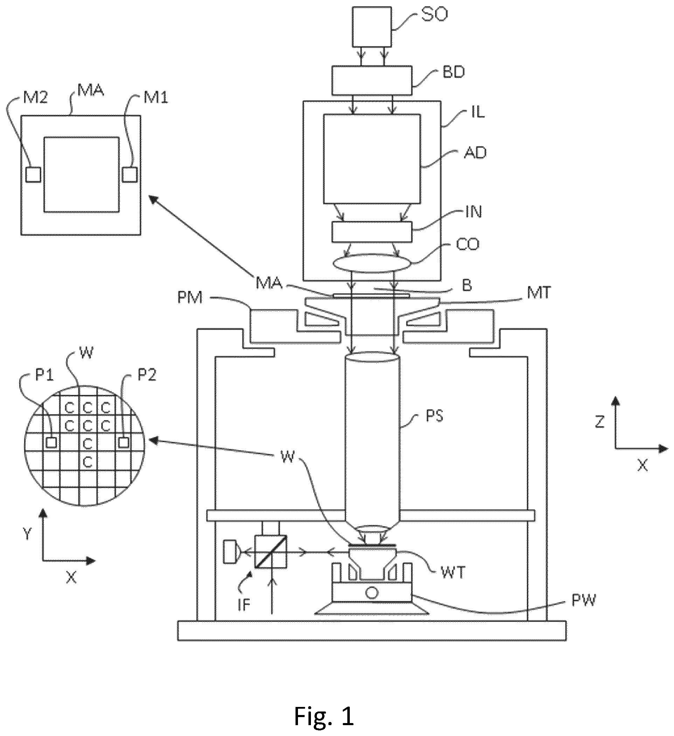

Figure 1 schematically depicts a lithographic apparatus according to one embodiment of the invention. The apparatus comprises an illumination system IL, a support structure MT, a substrate table WT and a projection system PS.

The illumination system IL is configured to condition a radiation beam B. The support structure MT (e.g. a mask table) is constructed to support a patterning device MA (e.g. a mask) and connected to a first positioner PM configured to accurately position the patterning device in accordance with certain parameters. The substrate table WT (e.g. a wafer table) is constructed to hold a substrate W (e.g. a resist-coated wafer) W and connected to a second positioner PW configured to accurately position the substrate in accordance with certain parameters. The projection system PS is configured to project a pattern imparted to the radiation beam B by patterning device MA onto a target portion C (e.g. comprising one or more dies) of the substrate W.

The illumination system IL may include various types of optical components, such as refractive, reflective, magnetic, electromagnetic, electrostatic or other types of optical components, or any combination thereof, for directing, shaping, or controlling radiation.

The term "radiation beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The support structure MT supports, i.e. bears the weight of, the patterning device MA. The support structure MT holds the patterning device MA in a manner that depends on the orientation of the patterning device MA, the design of the lithographic apparatus, and other conditions, such as for example whether or not the patterning device MA is held in a vacuum environment. The support structure MT can use mechanical, vacuum, electrostatic or other clamping techniques to hold the patterning device MA. The support structure MT may be a frame or a table, for example, which may be fixed or movable as required. The support structure MT may ensure that the patterning device MA is at a desired position, for example with respect to the projection system PS.

The term "patterning device" used herein should be broadly interpreted as referring to any device that can be used to impart a radiation beam B with a pattern in its cross-section such as to create a pattern in a target portion C of the substrate W. It should be noted that the pattern imparted to the radiation beam B may not exactly correspond to the desired pattern in the target portion C of the substrate W, for example if the pattern includes phase-shifting features or so called assist features. Generally, the pattern imparted to the radiation beam will correspond to a particular functional layer in a device being created in the target portion C, such as an integrated circuit.

The patterning device MA may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam B in different directions. The tilted mirrors impart a pattern in a radiation beam B which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum.

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables WT (and/or two or more mask tables). In such "multiple stage" machines the additional tables may be used in parallel, or preparatory steps may be carried out on one or more tables while one or more other tables are being used for exposure. In addition to one or more substrate tables WT, the lithographic apparatus may have a measurement stage that is arranged to be at a position beneath the projection system PS when the substrate table WT is away from that position. Instead of supporting a substrate W, the measurement stage may be provided with sensors to measure properties of the lithographic apparatus. For example, the projection system may project an image on a sensor on the measurement stage to determine an image quality.

The lithographic apparatus may also be of a type wherein at least a portion of the substrate W may be covered by a liquid having a relatively high refractive index, e.g. water, so as to fill a space between the projection system and the substrate. An immersion liquid may also be applied to other spaces in the lithographic apparatus, for example, between the patterning device MA and the projection system PS. Immersion techniques are well known in the art for increasing the numerical aperture of projection systems. The term "immersion" as used herein does not mean that a structure, such as a substrate W, must be submerged in liquid, but rather only means that liquid is located between the projection system PS and the substrate W during exposure.

Referring to figure 1, the illumination system IL receives a radiation beam B from a radiation source SO. The radiation source SO and the lithographic apparatus may be separate entities, for example when the radiation source SO is an excimer laser. In such cases, the source is not considered to form part of the lithographic apparatus and the radiation beam B is passed from the radiation source SO to the illumination system IL with the aid of a beam delivery system BD comprising, for example, suitable directing mirrors and/or a beam expander. In other cases the radiation source SO may be an integral part of the lithographic apparatus, for example when the radiation source SO is a mercury lamp. The radiation source SO and the illuminator IL, together with the beam delivery system BD if required, may be referred to as a radiation system.

The illumination system IL may comprise an adjuster AD for adjusting the angular intensity distribution of the radiation beam B. Generally, at least the outer and/or inner radial extent (commonly referred to as s-outer and s-inner, respectively) of the intensity distribution in a pupil plane of the illumination system can be adjusted. In addition, the illumination system IL may comprise various other components, such as an integrator IN and a condenser CO. The illumination system IL may be used to condition the radiation beam B, to have a desired uniformity and intensity distribution in its cross-section.

The radiation beam B is incident on the patterning device MT, which is held on the support structure MT, and is patterned by the patterning device MA. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module and a short-stroke module, which form part of the first positioner PM. The long-stroke module may provide coarse positioning of the short-stroke module over a large range of movement. The short-stroke module may provide fine positioning of the support structure MT relative to the long-stroke module over a small range of movement. Similarly, movement of the substrate table WT may be realized using a long-stroke module and a short-stroke module, which form part of the second positioner PW. The long-stroke module may provide coarse positioning of the short-stroke module over a large range of movement. The short-stroke module may provide fine positioning of the substrate table WT relative to the long-stroke module over a small range of movement. In the case of a stepper (as opposed to a scanner) the support structure MT may be connected to a short-stroke actuator only, or may be fixed. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions C (these are known as scribe-lane alignment marks). Similarly, in situations in which more than one die is provided on the patterning device MA, the mask alignment marks M1, M2 may be located between the dies.

The depicted apparatus could be used in at least one of the following modes:

In a first mode, the so-called step mode, the support structure MT and the substrate table WT are kept essentially stationary, while an entire pattern imparted to the radiation beam B is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

In a second mode, the so-called scan mode, the support structure MT and the substrate table WT are scanned synchronously while a pattern imparted to the radiation beam B is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

In a third mode, the support structure MT is kept essentially stationary holding a programmable patterning device, and the substrate table WT is moved or scanned while a pattern imparted to the radiation beam B is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

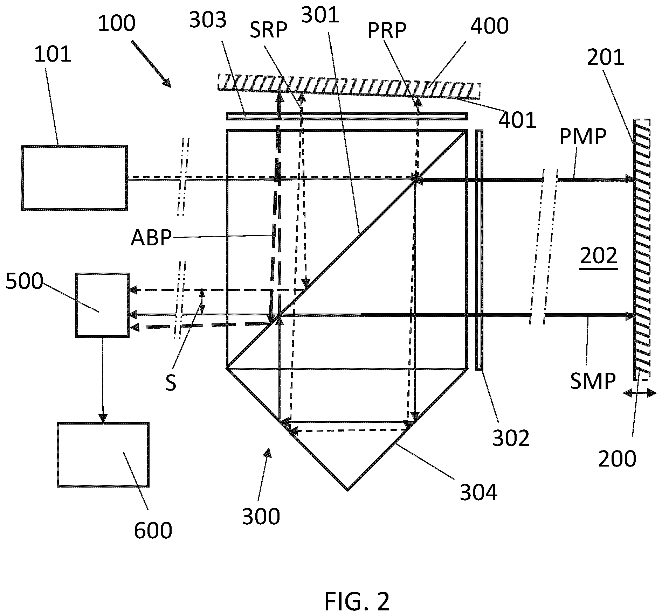

Figure 2 shows a known embodiment of a position measurement system 100. The position measurement system 100 is an interferometer system and is arranged to determine a position of a movable object 200, for example a part of a projection system PS, a substrate support WT or a patterning device support MT of a lithographic apparatus. The movable object 200 comprises a measurement surface 201. This measurement surface 201 is flat and reflective.

The position measurement system 100 of Figure 2 is a heterodyne interferometer system. In alternative embodiments, the interferometer system may be a homodyne interferometer system or another type of interferometer system.

The position measurement system 100 comprises a light source 101 configured to provide a measurement beam and a reference beam. The measurement beam and the reference beam may be provided as a single light beam, wherein the measurement beam has a first polarization and the reference beam has a second polarization, wherein the first polarization and the second polarization are orthogonal to each other. Moreover, the measurement beam may have a first frequency and the reference beam may have a second frequency different from the first frequency.

The light source 101 may for example comprise a laser source to provide a light beam, a first polarization and frequency shift device, a second polarization and frequency shift device, and a Rochon prism. The laser source may be configured to provide a light beam with a first fixed light frequency and is for example a stabilized HeNe laser source. The first polarization and frequency shift device is arranged to provide the first polarization and the first frequency in the measurement beam and the second polarization and frequency shift device is arranged to provide the second polarization and the second frequency in the reference beam. The Rochon prism is arranged to recombine the measurement beam and reference beam. In some embodiments, any appropriate means other than a Rochon prism may be used to recombine the measurement beam and the reference beam.

The light source 101 is described as an example of a light source to provide a measurement beam and a reference beam. In other embodiments, any other way of providing the measurement beam and the reference beam may also be applied.

The measurement beam and the reference beam are guided to interferometer optics 300 of a measurement axis 202. The interferometer optics 300 comprise a polarizing beam splitter 301. Since the measurement beam has the first polarization and the reference beam has the second polarization, the polarizing beam splitter 301 is thus configured to guide the measurement beam and the reference beam along different paths.

The interferometer optics 300 further comprises a first quarter wave plate 302 and a second quarter wave plate 303. The first quarter wave plate 302 and the second quarter wave plate 303 are configured to rotate the polarization of a light beam passing twice the first quarter wave plate 302 or passing twice the second quarter wave plate 303 with 90 degrees. This has the result that light having the first polarization that passes twice the first quarter wave plate 302 or the second quarter wave plate 303 will change to light having the second polarization and light having the second polarization that passes twice the first quarter wave plate 302 or the second quarter wave plate 303 will change to light having the first polarization.

The position measurement system 100 is a dual pass system having two successive passes. This means that the measurement beam is passed twice towards the measurement surface 201 and the reference beam is passed twice towards a reference surface 401. The reference surface 401 is a flat reflective surface and may be mounted on a reference object 400. Hereinafter, the path of the first pass is referred to as primary path and the path of the subsequent second pass is referred to as secondary path.

For the primary pass, the interferometer optics 300 are arranged to guide the measurement beam as a primary path measurement beam along a primary measurement path PMP to the measurement surface 201 and the reference beam as a primary path reference beam along a primary reference path PRP to the reference surface 401.

After reflection of the primary path measurement beam on the measurement surface 201, the interferometer optics 300 will receive the primary path measurement beam as a reflected primary path measurement beam. During this first pass, the primary path measurement beam and the reflected primary path measurement beam will pass the first quarter wave plate 302 with the result that the polarization of the measurement beam will change from the first polarization to the second polarization.

Correspondingly, after reflection of the primary path reference beam on the reference surface 401, the interferometer optics 300 will receive the primary path reference beam as a reflected primary path reference beam. During this first pass, the primary path reference beam and the reflected primary path reference beam will pass the second quarter wave plate 303 with the result that the polarization of the reference beam will change from the first polarization to the second polarization.

Due to this change in polarization, the reflected primary path measurement beam will now be reflected on the polarizing beam splitter 301, while the reflected primary path reference beam will be transmitted through the polarizing beam splitter 301.

The reflected primary path measurement beam and the reflected primary path reference beam will be reflected by a corner cube 304 back to the polarizing beam splitter 301. The corner cube 304 is therefore configured to return the incident beam at an angle of 180 degrees, i.e. incident beam is parallel to returning beam. Instead of a corner cube 304 any other suitable retro reflector may also be applied.

The reflected primary path measurement beam will again be reflected on the polarizing beam splitter 301 and the reflected primary path reference beam will be transmitted through the polarizing beam splitter 301 to start the secondary pass.

In the secondary pass, the reflected primary path measurement beam is guided as a secondary path measurement beam along a secondary measurement path SMP to the measurement surface 201 and reflected primary path reference beam is guided as a secondary path reference beam along a secondary reference path SRP to the reference surface 401.

After reflection of the secondary path measurement beam on the measurement surface 201, the interferometer optics 300 will receive the secondary path measurement beam as a reflected secondary path measurement beam. During this second pass, the secondary path measurement beam and the reflected secondary path measurement beam will pass the first quarter wave plate 302 with the result that the polarization of the measurement beam will change again from the second polarization to the first polarization.

Correspondingly, after reflection of the secondary path reference beam on the reference surface 401, the interferometer optics 300 will receive the secondary path reference beam as a reflected secondary path reference beam. During this second pass, the secondary path reference beam and the reflected secondary path reference beam will pass the second quarter wave plate 303 with the result that the polarization of the reference beam will change again from the second polarization to the first polarization.

Due to this change in polarization, the reflected secondary path measurement beam will now be transmitted through the polarizing beam splitter 301, while the reflected secondary path reference beam will be reflected on the polarizing beam splitter 301. The combined reflected secondary path measurement beam and the reflected secondary path reference beam, hereinafter also referred to as reflected measurement beam and reflected reference beam propagate to a detector 500, for example a light detector. On the basis of the received light of the reflected measurement beam and reflected reference beam, the light detector 500 may provide an interferometer signal. This interferometer signal may be guided to a processing unit 600 that may determine a change in the position of the movable object 200 with respect to the reference object 400 based on the interferometer signal.

In the interferometer optics 300 ghost reflections and/or polarization leakages at the interferometer polarizing beam splitter 301 may occur. These ghost reflections and/or polarization leakages may lead to additional beams paths in the interferometer optics 300.

These additional beam paths may follow the primary and/or secondary measurement paths PMP, SMP and/or the primary and/or secondary reference paths PRP, SRP, but may also remain within the interferometer optics 300.

These additional beam paths may subsequently reach the detector 500 where the additional beam paths are detected alongside with the reflected secondary path light beam. These additional beam paths may therefore lead to measurement errors. These measurement errors are undesirable.

One type of additional beam path that may occur is an additional beam path in which a beam is reflected both on the measurement surface 201 and the reference surface 401. An example of such additional beam path ABP resulting from polarization leakage is shown in Figure 2, in which a part of the measurement beam, after being reflected by the corner cube 304 is transmitted by the polarizing beam splitter 301 towards the reference surface 401 instead of being reflected towards the measurement surface 201.

To suppress that this type of additional beam path negatively affects the position measurement of the position measurement system 100, the reference surface 401 of the position measurement system 100 is tilted such that an incident angle of the reference beam incident on the reference surface 401 is non-perpendicular with respect to the reference surface 401. The reference beam incident on the reference surface 401 may for example have an offset angle in the range of from about 0.1 to 10 milliradians with respect to the normal to said reference surface 401.

Due to the tilted reference surface 401, a beam that will be reflected once by the measurement surface 201 and once by the reference surface 401 will, as shown in the additional beam path ABP of Figure 2, have a different angle towards the detector 500 than the reflected reference beam that is reflected twice by the reflective surface 401 and the measurement beam that is reflected twice by the measurement surface 201. By providing this different angle of the additional beam, the effect of the additional beam on the position measurement may at least partially be suppressed.

It is noted that in the embodiment of Figure 2, the reference surface 401 is tilted. In alternative embodiments, any other reflective surface in the measurement paths or the reference paths may be tilted, such that an incident angle of the measurement beam or reference beam incident on the respective reflective surface is at a non-90 degrees angle and at a non-45 degrees angle with respect to the reflective surface. For example, the measurement beam or reference beam incident on the reflective surface may have an offset angle in the range of from about 0.1 to 10 milliradians with respect to the normal of the reflective surface or with respect to a 45 degrees angle with respect to the normal of the reflective surface.

US2005110971, the contents of which is herein incorporated by reference, discloses further details of an interferometer system in which a tilted reflective surface is provide to suppress the effect of this type of additional beam types.

Although tilting the reference surface 401, as shown in the embodiment of Figure 2, or tilting any other reflective surface in the measurement paths or the reference paths may effectively help to suppress the effect of the type additional beam paths in which a beam is reflected both on the measurement surface 201 and the reference surface 401, the tilted surface, e.g. the tilted reference surface 401 in embodiment of Figure 2, has the effect that the reflected measurement beam and the reflected reference beam are shifted with respect to each other by a shift distance S.

This shift distance S causes a smaller overlap of the reflected measurement beam and the reflected reference beam received by the detector 500 resulting in a measurement signal having a smaller interference signal intensity. With increasing shift distance S, the overlap of the reflected measurement beam and the reflected reference beam becomes smaller until there is no overlap anymore. The shift distance S may become larger with increasing angles of the tilted reflective surface, for example the tilted reference surface 401, and with increasing lengths of the light beam paths in which the tilted reflective surface is placed.

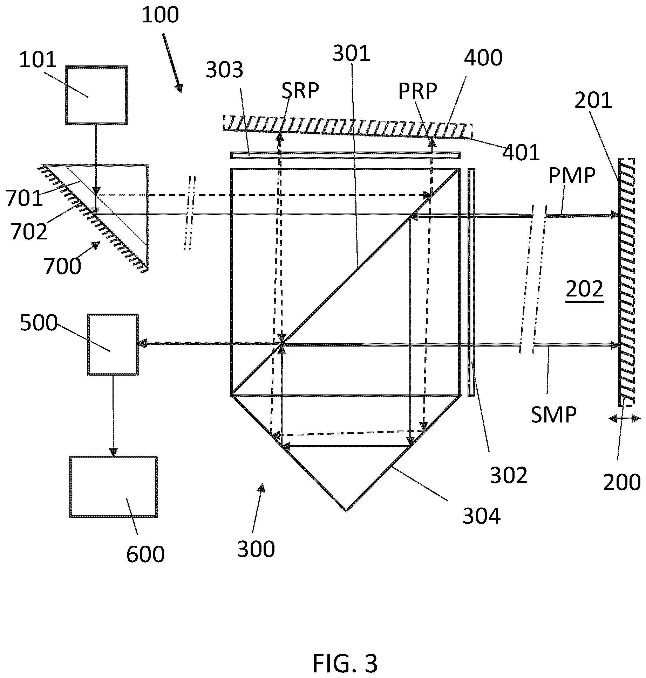

Figure 3 shows a first embodiment of a position measurement system 100 according to the invention. The position measurement system 100 of Figure 3 mainly corresponds with the interferometer system of Figure 2. In the embodiment of Figure 3, the orientation of the light source 101 is tilted over an angle of 90 degrees with respect to the orientation of the light source 101 in the embodiment of Figure 2.

An optical device 700 is arranged in the common light path of the measurement beam and the reference beam between the light source 101 and the interferometer optics 300. Thus, the optical device 700 is downbeam of the light source 101 and upbeam of the interferometer optics 300. The optical device 700 is configured to induce a position (and/or angle) offset between the measurement beam and the reference beam. This offset introduced between the measurement beam and the reference beam may be selected to be the same or substantially the same as the offset that results from the tilted reference surface 401, or at least to increase the overlap between the reflected measurement beam and the reflected reference beam received by the detector 500.

The optical device 700 comprises a polarizing beam splitter 701 and a mirror surface 702. The polarizing beam splitter 701 is arranged to transmit the measurement beam and to reflect the reference beam. The mirror surface 702 will reflect the measurement beam transmitted by the polarizing beam splitter 701.

The polarizing beam splitter 701 and the mirror surface 702 are arranged parallel to each other such that the measurement beam and the reference beam after reflection on the mirror surface 702 and the polarizing beam splitter 701 remain parallel to each other. Further, the polarizing beam splitter 701 and the mirror surface 702 are arranged at an angle of 45 degrees with respect to the angle of incidence of the measurement beam and the reference beam such that optical device 700 will deflect the measurement beam and the reference beam over an angle of 90 degrees, while inducing the offset between the measurement beam and the reference beam.

It can be seen that, due to the offset the reflected measurement beam and the reflected reference beam incident on the detector 400 substantially overlap. Thus, the embodiment of Figure 3 applies a tilted reference surface 401 to mitigate the effect of the additional beam paths in which a beam is reflected both on the measurement surface 201 and the reference surface 401 and comprises an optical device 700 to at least partially compensate for the offset between the reflected measurement beam and the reflected reference beam caused by the tilted reference surface 401.

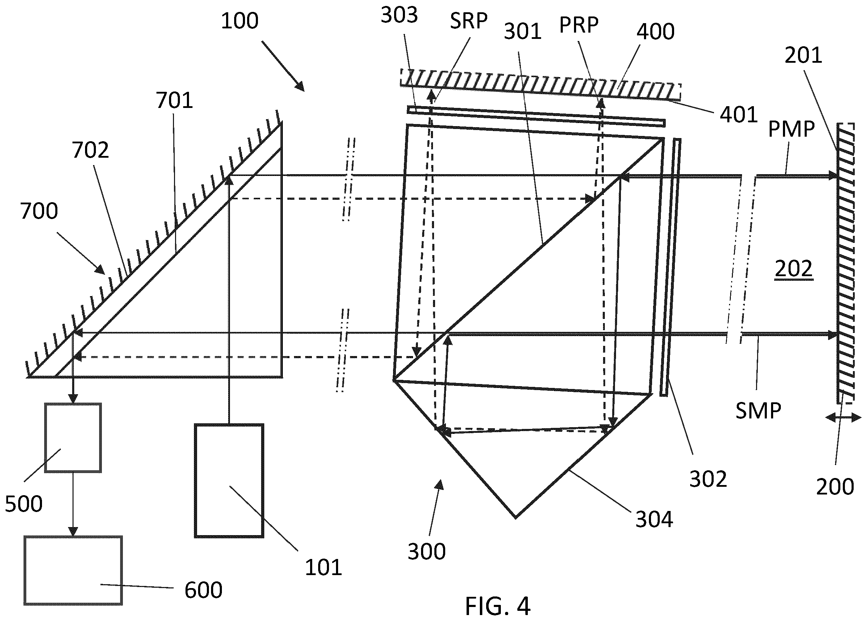

Figure 4 shows a second embodiment of a position measurement system 100 according to the invention. In this embodiment, both the interferometer optics 300 and the reference surface 401 are tilted such that an incident angle of the measurement beam or reference beam incident on the reflective surfaces of the interferometer optics 300 and the reference surface 401 is at a non-90 degrees angle and at a non-45 degrees angle with respect to the respective reflective surface. By using these tilted interferometer optics 300 and reference surface 401, the position measurement of the measurement surface 201 with respect to the reference surface is not negatively affected by an additional beam path in which a beam is reflected both on the measurement surface 201 and the reference surface 401.

An optical device 700 is arranged in the common light path of the measurement beam and the reference beam between the light source 101 and the interferometer optics 300. Thus, the optical device 700 is arranged downbeam of the light source 101 and upbeam of the interferometer optics 300. The optical device 700 is also arranged to reflect the reflected measurement beam and the reflected reference beam after the final pass of the multiple passes and before the reflected measurement beam and the reflected reference beam are received by the detector 500. Thus, the optical device 700 is also provided arranged downbeam of the interferometer optics 300 and upbeam of the detector 500.

The optical device 700 is configured to induce an offset between the measurement beam and the reference beam and between the reflected measurement beam and the reflected reference beam. This double offset introduced between the measurement beam and the reference beam may be selected to at least partially compensate the offset between the reflected measurement beam and the reflected reference beam that is induced by the tilted interferometer optics 300 and tilted reference surface 401.

The optical device 700 comprises a polarizing beam splitter 701 and a mirror surface 702. The polarizing beam splitter 701 is arranged to transmit the measurement beam and the reflected measurement beam and to reflect the reference beam and the reflected reference beam. The mirror surface 702 will reflect the measurement beam and the reflected measurement beam transmitted by the polarizing beam splitter 701.

In the embodiment of Figure 4, the polarizing beam splitter 701 and the mirror surface 702 are arranged substantially parallel to each other. An advantage of the embodiment of Figure 4 is that, since both the measurement beam and the reflected measurement beam are reflected by the mirror surface 702 and both the reference beam and the reflected reference beam are reflected by the polarizing beam splitter 701, any non-parallelism between the polarizing beam splitter 701 and a mirror surface 702 will be compensated by the double reflection in combination with the reflection of the measurement beam and the reference beam in the corner cube 304. This may reduce the manufacturing tolerances of the optical device 700 and therefore costs.

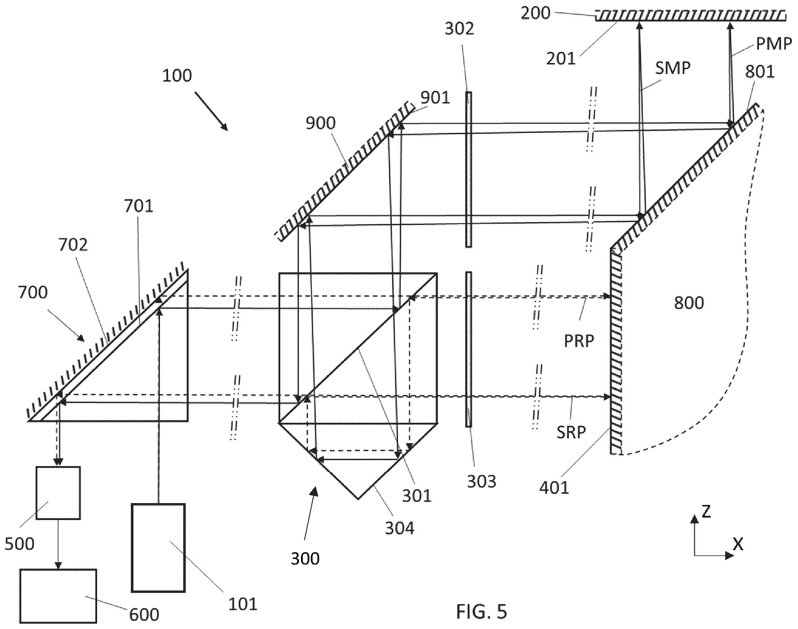

Figure 5 shows a third embodiment of a position measurement system 100 according to the invention. The position measurement system 100 of Figure 5 is a differential interferometer position measurement system. In this configuration of the position measurement system 100 comprises a measurement surface 201 mounted on a target object 200. The position measurement system 100 is configured to measure a position in z-direction with respect to another object 800. The other object 800 may be a stage.

The reference surface 401 is arranged on the other object 800. The paths of the first pass and the second pass of the reference beams run in mainly x-direction between the interferometer optics 300 and the reference surface 401.

The paths of the first pass and the second pass of the measurement beams extend from the interferometer optics 300 in mainly the z-direction to a first deflection surface 901 on a deflection element 900. On the first deflection surface 901 the measurement beams are deflected in mainly the x-direction towards a second deflection surface 801 on the other object 800. On the second deflection surface 801, the measurement beams are deflected again in mainly the z-direction towards the measurement surface 201. After reflection on the measurement surface 201 the measurement beams are reflected via the second deflection surface 801 and the first deflection surface 901 back to the interferometer optics 300. Since both the measurement beam paths and the reference beam paths are reflected on the other object 800, for example a stage, this interferometer system 100 is referred to as a differential position measurement system or differential interferometer system.

In the embodiment shown in Figure 5, the first deflection surface 901 is tilted such that an incident angle of the measurement beam incident on the first deflection surface 901 is not at an angle of 45 degrees with respect to the first deflection surface 901. The measurement beam incident on the first deflection surface 901 may for example have an offset angle in the range of from about 0.1 to 10 milliradians with respect to an angle of 45 degrees with respect to the first deflection surface 901.

As a result of this tilted first deflection surface 901 any additional beam path that is reflected once on the measurement surface 201 and once on the reference surface 401, will reach the detector 500 at another angle than the reflected measurement beam and reflected reference beam incident on the detector 500. This additional beam path will therefore not have a negative effect on the position measurement. In an alternative embodiment, the measurement surface 201 may be tilted to obtain this effect.

To at least partially compensate a shift between the reflected measurement beam and the reflected reference beam resulting from the tilted first deflection surface 901, the optical device 700 is provided in the beam path of the measurement beam and the reference beam between the light source 101 and the interferometer optics 300, and in the beam path of the reflected measurement beam and the reflected reference beam between the interferometer optics 300 and the detector 500.

The optical device 700 comprises a polarizing beam splitter 701 and a mirror surface 702. The polarizing beam splitter 701 and the mirror surface 702 are parallel to each other. The polarizing beam splitter 701 is arranged to reflect the measurement beam and the reflected measurement beam and to reflect the reference beam and the reflected reference beam. The mirror surface 702 will reflect the reference beam and the reflected reference beam transmitted by the polarizing beam splitter 701.

In the embodiment of Figure 5, the shift induced by the tilted first deflection surface 901 between the reflected measurement beam and the reflected reference beam received by the detector 500 may depend on the position of the other object 800 in the x-direction. Therefore, the optical device cannot exactly compensate the induced shift for any position of the other object 800.

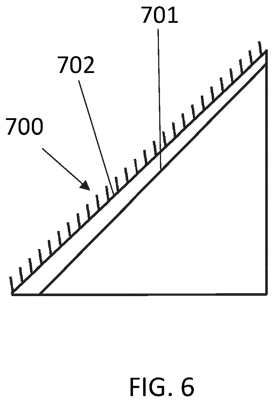

Figure 6 shows an alternative embodiment of the optical device 700, in which the polarizing beam splitter 701 and the mirror surface 702 are arranged at a non-zero angle with respect to each other. This angle between the polarizing beam splitter 701 and the mirror surface 702 can be arranged to make the offset between the reflected measurement beam and the reflected reference beam induced by a tilted surface in the measurement beams independent from the position of the other object 800.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A position measurement system, comprising:
a light source to provide a measurement beam and a reference beam propagating along a common light beam path,
an optical device located in the common light beam path and downbeam of the light source, wherein the optical device is configured to induce or adjust an offset between the measurement beam and the reference beam,
interferometer optics downbeam of the optical device, the interferometer optics configured to propagate the measurement beam in multiple passes along measurement paths to a measurement surface and the reference beam in multiple passes along reference paths to a reference surface, and
a detector to receive a reflected measurement beam and a reflected reference beam after a final pass of the multiple passes,
wherein a reflective surface in the measurement paths or the reference paths is tilted, such that an incident angle of the measurement beam or reference beam incident on the respective reflective surface is at a non-90 degrees angle and at a non-45 degrees angle with respect to the reflective surface.

2. The position measurement system of claim 1, wherein the reflective surface in the measurement paths or the reference paths is the measurement surface or reference surface, respectively.

3. The position measurement system of claim 1 or 2, wherein the optical device comprises a polarizing beam splitter and a mirror surface, wherein one of the polarizing beam splitter and the mirror surface is arranged to reflect the measurement beam and an other of the polarizing beam splitter and the mirror surface is arranged to reflect the reference beam.

4. The position measurement system of claim 3, wherein the polarizing beam splitter and the mirror surface of the optical device are arranged parallel to each other.

5. The position measurement system of any of the claims 1 or 2, wherein the optical device is further arranged to reflect the reflected measurement beam and the reflected reference beam after the final pass of the multiple passes before the reflected measurement beam and the reflected reference beam are received by the detector.

6. The position measurement system of claim 5, wherein the optical device comprises a polarizing beam splitter and a mirror surface, wherein one of the polarizing beam splitter and the mirror surface is arranged to reflect the measurement beam and the reflected measurement beam and the other of the polarizing beam splitter and the mirror surface is arranged to reflect the reference beam and the reflected reference beam.

7. The position measurement system of claim 6, wherein the polarizing beam splitter and the mirror surface of the optical device are arranged parallel to each other.

8. The position measurement system of claim 6, wherein the polarizing beam splitter and the mirror surface of the optical device are arranged at a non-zero angle with respect to each other.

9. The position measurement system of claim 8, wherein the non-zero angle is selected to make a beam offset between the reflected measurement beam and the reflected reference beam induced by the tilted reflective surface independent from a position change of the measurement surface and/or another movable surface reflecting the measurement beam.

10. The position measurement system of any of the preceding claims, wherein the optical device is configured to induce or adjust the offset between the measurement beam and the reference beam to at least partially compensate an offset between the reflected measurement beam and the reflected reference beam induced by the tilted reflective surface in the measurement paths or the reference paths.

11. The position measurement system of any of the preceding claims, wherein the position measurement system is a differential interferometer position measurement system.

12. The position measurement system of any of the preceding claims, wherein the interferometer optics comprise a retro reflector, wherein the retro reflector is arranged to reflect the measurement beam and the reference beam at least once.

13. A projection system for an optical lithography system comprising the position measurement system of any of the claims 1-12.

14. An exposure apparatus, for example a lithographic apparatus, comprising the interferometer system of any of the claims 1-12.

15. A method to measure a position of an object using the position measurement system of any of the claims 1-12.
